# EUROPEAN PATENT SPECIFICATION

(11) **EP 4 207 247 B1**
(45) Date of publication and mention of the grant of the patent: **05.11.2025**
(21) Application number: 21871345.1
(22) Date of filing: 14.09.2021
(51) Int. Cl.: H01L 21/20, H10D 62/815, H10D 30/47, H10D 62/17, H10D 62/85, H10H 20/812, H10H 20/815, H10H 20/825

(54) **NITRIDE EPITAXIAL STRUCTURE AND SEMICONDUCTOR DEVICE**
EPITAKTISCHE NITRIDSTRUKTUR UND HALBLEITERBAUELEMENT
STRUCTURE ÉPITAXIALE DE NITRURE ET DISPOSITIF À SEMI-CONDUCTEUR

(30) Priority: 25.09.2020 CN 202011025013
(43) Date of publication of application: 05.07.2023
(73) Proprietor: Huawei Technologies Co., Ltd., Shenzhen, Guangdong 518129 (CN)
(72) Inventor: CHEN, Zhibin, Shenzhen, Guangdong 518129 (CN); LUO, Ruihong, Shenzhen, Guangdong 518129 (CN)
(74) Representative: Goddar, Heinz J.
(86) International application number: PCT/CN2021/118342
(87) International publication number: WO 2022/062974

(56) References cited:
- CN-A- 103 236 477
- CN-A- 103 806 104
- CN-A- 104 885 198
- CN-A- 109 216 520
- US-A1- 2013 168 691
- US-A1- 2015 318 448
- US-A1- 2015 340 230
- US-A1- 2019 006 178

## Description

### TECHNICAL FIELD

This application relates to the field of semiconductor technologies, and in particular, to a nitride epitaxial structure and a semiconductor device.

### BACKGROUND

Gallium nitride (GaN) materials have advantages such as a large band gap and high mobility, and therefore are widely used in electronic power devices, radio frequency devices, and photoelectric devices. A high electron mobility transistor (High Electron Mobility Transistor, HEMT) is the most widely used. A gallium nitride material is usually obtained through epitaxial growth on a silicon substrate. However, a large lattice mismatch and a thermal expansion coefficient mismatch of more than 17% occur between GaN and silicon. Therefore, a large stress is generated in a silicon-based gallium nitride, and the stress causes warpage in epitaxy, affecting uniformity and reliability of a GaN epitaxial wafer. In addition, with an increase of a size of the substrate, impact of warpage is increasingly significant. Currently, in the conventional technology, stress is mainly adjusted by using a gradient AlGaN structure and a superlattice structure. However, the gradient AlGaN structure has disadvantages of poor dynamic performance and poor crystal quality. Although a stress control capability and crystal quality of the superlattice structure are better than those of the gradient AlGaN structure, voltage withstand performance and crystal quality are difficult to balance.
US 2015/340230 A1 discloses a III nitride epitaxial substrate with reduced warp after the formation of a main laminate and improved vertical breakdown voltage, and a method of producing the same, a III nitride epitaxial substrate includes: a Si substrate; an initial layer in contact with the Si substrate; and a superlattice laminate formed on the initial layer, the superlattice laminate including first layers made of Al_{α}Ga_{1-α}N (0.5<α≦ 1) and second layers made of Al_{β}Ga_{1-β}N(0<β≦0.5) that are alternately stacked, in which a composition ratio β of the second layers gradually increases as a distance from the Si substrate increases.
US 2019/006178 A1 discloses a semiconductor device including a substrate, a semiconductor layer, and a buffer structure. The semiconductor layer is located on the substrate. The buffer structure is located between the substrate and the semiconductor layer. The buffer structure includes a plurality of first layers and a plurality of second layers. The first layers and the second layers are alternately stacked with a same pitch or different pitches.
US 2015/318448 A1 discloses an LED epitaxial structure includes a substrate; a GaN nucleating layer; a superlattice buffer layer comprising a plurality pairs of alternately stacked AlGaN/n-GaN structures; an n-GaN layer; a MQW light-emitting layer, a p-GaN layer and a p-type contact layer. Al(n) represents Al composition value of the n*^{th}* AlGaN/n-GaN superlattice buffer layer pair; N(n) represents n-type impurity concentration value of the n*^{th}* AlGaN/n-GaN superlattice buffer layer pair; variation trend of Al(n) is from gradual increase to gradual decrease, and for N(n) is from gradual increase to gradual decrease. The structure can effectively and sufficiently release the lattice stress due to lattice mismatch between the sapphire substrate and GaN at the bottom layer growth section, thereby greatly reducing wrapping of the epitaxial wafer throughout high-temperature growth process, improving wavelength concentration and yield of the epitaxial wafer, improving GaN lattice quality, reducing lattice dislocation density and improving stability of photoelectric characteristics.

### SUMMARY

The invention provides a nitride epitaxial structure of claim 1 and a semiconductor device of claim 11. Further embodiments are disclosed in the dependent claims. A buffer layer of a specific structure is disposed between a substrate and an epitaxial layer, to effectively alleviate and release stress generated between the substrate and the epitaxial layer due to a lattice mismatch and a thermal mismatch, reduce warpage during epitaxy and after epitaxy, and improve uniformity and reliability of the nitride epitaxial structure. Further, crystal quality and voltage withstand performance of the epitaxial layer can be improved, thereby effectively improving performance of the semiconductor device.

Specifically, a first aspect of embodiments of this application provides a nitride epitaxial structure of claim 1, including:
a substrate;
a nucleation layer, formed on the substrate, where the nucleation layer is an aluminum nitride layer or a gallium nitride layer;
a buffer layer, formed on the nucleation layer, where the buffer layer includes K stacked group-III nitride double-layer structures, K ≥ 3, each double-layer structure includes an upper layer and a lower layer that are stacked, a band gap of a material of the upper layer is greater than a band gap of a material of the lower layer, a band gap difference of each double-layer structure is a difference between the band gap of the material of the upper layer and the band gap of the material of the lower layer, and band gap differences of the K double-layer structures generally present a gradient trend along a thickness direction of the buffer layer; and
an epitaxial layer, formed on the buffer layer, where a material of the epitaxial layer includes a group-III nitride.

The nucleation layer may provide a nucleation center for subsequent growth of the nitride epitaxial layer, to alleviate a lattice mismatch between the substrate and the epitaxial layer, and may further effectively prevent impurities brought by the substrate from affecting subsequent growth of the nitride epitaxial layer, thereby improving crystal quality of the epitaxial layer. The buffer layer is disposed between the substrate and the epitaxial layer, to effectively alleviate and release stress generated between the substrate and the epitaxial layer due to a lattice mismatch and a thermal mismatch, reduce warpage during epitaxy and after epitaxy, and improve uniformity and reliability of the nitride epitaxial structure. In addition, the buffer layer is disposed by stacking a plurality of group-III nitride double-layer structures with gradient band gap differences, so that dynamic performance is good, crystal quality and voltage withstand performance can be effectively balanced, and an electric leakage risk can be reduced, thereby effectively improving performance of a semiconductor device. In addition, double-layer structures with different band gap differences are adaptively used at different locations, so that advantages of filtering dislocations and improving voltage withstand performance can be both achieved, and a balance between the two aspects of performance can be achieved according to an actual requirement. The dynamic performance usually refers to a recovery capability of a transistor after electrical stress is increased, and may be measured by using an indicator such as Dron (dynamic resistance).

In an implementation of this application, in each double-layer structure, the material of the upper layer and the material of the lower layer each are selected from one of GaN, AlN, InN, or a combination thereof: AlGaN, InGaN, InAlN, or InAlGaN. Specifically, a combination of the materials of the upper layer and the lower layer of the double-layer structure may be AlN/GaN, AlGaN/GaN, AlN/AlGaN, or AlGaN/AlGaN.

In an implementation of this application, a thickness of the lower layer is greater than twice a thickness of the upper layer. A thick lower layer and a thick upper layer are disposed, so that lattice relaxation can be effectively avoided. For heteroepitaxy, when the thickness of the upper layer is smaller, the material is in a strained state, to be specific, a lattice constant of the material of the upper layer is the same as that of the material of the lower layer after the material of the upper layer is stretched or compressed by the material of the lower layer, so that a superlattice can effectively function; or when the thickness of the upper layer is greater, the material is restored to a lattice constant of the material, causing lattice relaxation.

In an implementation of this application, the band gap differences of the K double-layer structures gradually decrease from one side of the nucleation layer to one side of the epitaxial layer. When the band gap difference is large, a difference between lattice constants of the materials of the double-layer structure is large, thereby helping filter dislocations. However, because a polarization effect is also strong, electric leakage is likely to occur. On the contrary, when the band gap difference is small, this helps reduce a leakage current, but is not conducive to dislocation filtering. A double-layer structure with a large band gap difference is disposed on a side close to the nucleation layer, thereby helping eliminate dislocations at an early stage of epitaxy and reduce impact of electric leakage. A double-layer structure with a small band gap difference is disposed on a side close to the epitaxial layer, thereby helping reduce a leakage current and improve voltage withstand performance.

In an implementation of this application, a difference between a largest band gap difference and a smallest band gap difference in the K double-layer structures is greater than 20% of a band gap difference between a group-III nitride with a largest band gap and a group-III nitride with a smallest band gap that constitute the double-layer structure. The difference between the largest band gap difference and the smallest band gap difference of the K double-layer structures of the entire buffer layer is controlled within an appropriate range, so that crystal quality and voltage withstand performance can be better balanced and adjusted.

According to the first aspect, the K double-layer structures include two types of group-III nitrides: GaN and AlN, and an average Al component content in each double-layer structure is 15% to 30%. The average Al component content is an average molar percentage of an Al element in group-III metal elements in each double-layer structure. An Al component content of each double-layer structure is controlled within an appropriate range, to ensure that the buffer layer has good crystal quality.

According to the first aspect, the average Al component content in each double-layer structure is the same. An Al component remains unchanged. Therefore, when pre-compensation is designed for high-temperature warpage, only impact of a thickness of a film layer needs to be considered, and impact of a change of the Al component does not need to be considered, thereby simplifying a parameter design.

In an implementation of this application, in the K double-layer structures, any two adjacent double-layer structures may have different band gap differences, or some adjacent double-layer structures may have a same band gap difference. A repetition periodicity of double-layer structures that are adjacently stacked and that have a same band gap difference may be 1 to 10.

In an implementation of this application, to avoid relaxation, a thickness of each double-layer structure is set to be less than 100 nm.

In an implementation of this application, a material of the epitaxial layer includes one or more of GaN, AlN, InN, AlGaN, InGaN, InAlN, and InAlGaN.

In an implementation of this application, a thickness of the epitaxial layer is greater than or equal to 300 nm. A thickness of a conventional gallium nitride epitaxial layer is usually small due to a limitation of stress. However, a nitride epitaxial wafer in embodiments of this application can well eliminate stress, and therefore theoretically may have an infinite thickness. In some implementations of this application, a thickness of the epitaxial layer may be greater than or equal to 5 µm, or may be greater than or equal to 10 µm.

In an implementation of this application, the substrate includes a silicon substrate, a sapphire substrate, a silicon-on-insulator substrate (SOI substrate), a gallium nitride substrate, a gallium arsenide substrate, an indium phosphide substrate, an aluminum nitride substrate, a silicon carbide substrate, a quartz substrate, or a diamond substrate.

In an implementation of this application, a thickness of the nucleation layer is 10 nm to 300 nm.

In an implementation of this application, the nitride epitaxial structure further includes a transition layer disposed between the nucleation layer and the epitaxial layer, and a material of the transition layer is AlGaN. In an implementation of this application, a material of the transition layer is the same as that of the nucleation layer. In an implementation of this application, a thickness of the transition layer is 10 nm to 300 nm.

In an implementation of this application, the nitride epitaxial structure further includes other functional layers disposed on the epitaxial layer. The other functional layers may be disposed according to an actual application requirement, and may specifically include an AlN insertion layer, an AlGaN barrier layer, a P-type GaN layer, and the like.

According to a second aspect, an embodiment of this application further provides a semiconductor device of claim 11, including the nitride epitaxial structure according to the first aspect of embodiments of this application. The semiconductor device may be a power device, a radio frequency device, or a photoelectric device. Specifically, for example, the semiconductor device is a field-effect transistor, a light emitting diode, or a laser diode.

In the nitride epitaxial structure provided in embodiments of this application, the nucleation layer is disposed on the substrate, and the buffer layer is disposed on the nucleation layer, thereby effectively alleviating and releasing stress generated between the substrate and the epitaxial layer due to a lattice mismatch and a thermal mismatch, reducing warpage during epitaxy and after epitaxy, improving uniformity and reliability of the nitride epitaxial structure, and further improving performance of the semiconductor device. In the semiconductor device provided in embodiments of this application, because the nitride epitaxial structure provided in embodiments of this application is used, a large-size thick nitride epitaxial layer device can be obtained, thereby effectively reducing device costs and improving device performance.

### BRIEF DESCRIPTION OF DRAWINGS

FIG. 1 is a schematic diagram of a structure of a nitride epitaxial structure according to an implementation of this application;
FIG. 2 is a schematic diagram of a structure of a nitride epitaxial structure according to another implementation of this application;
FIG. 3 is a schematic diagram of a structure of a nitride epitaxial structure according to still another implementation of this application;
FIG. 4 is a schematic diagram of a structure of a buffer layer according to an implementation of this application;
FIG. 5 is a schematic diagram of a structure of a nitride epitaxial structure according to an implementation of this application;
FIG. 6 is a flowchart of a preparation process for a nitride epitaxial structure according to an implementation of this application;
FIG. 7A is a TEM (Transmission Electron Microscope, transmission electron microscope) graph of a double-layer structure, of a buffer layer, that is close to a side of a substrate in a nitride epitaxial structure according to Embodiment 2;
FIG. 7B is an EDS (Energy Dispersive Spectroscopy, energy dispersive spectroscopy) graph of a double-layer structure, of a buffer layer, that is close to a side of a substrate in a nitride epitaxial structure according to Embodiment 2;
FIG. 8A is a TEM graph of a double-layer structure, of a buffer layer, that is close to a side of an epitaxial layer in a nitride epitaxial structure according to Embodiment 2; and
FIG. 8B is an EDS graph of a double-layer structure, of a buffer layer, that is close to a side of an epitaxial layer in a nitride epitaxial structure according to Embodiment 2.

### DESCRIPTION OF EMBODIMENTS

The following describes embodiments of this application with reference to accompanying drawings in embodiments of this application.

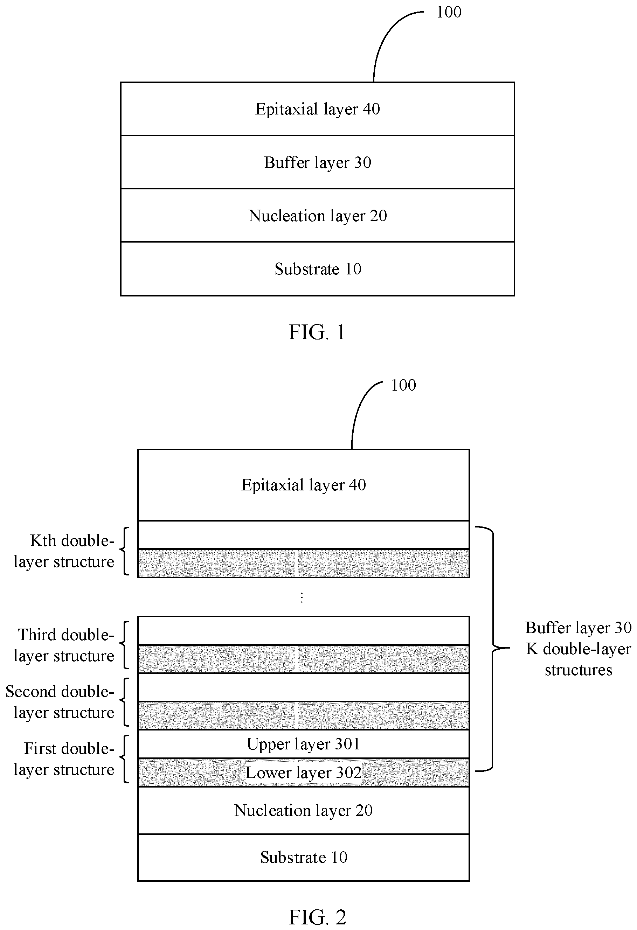

As shown in FIG. 1 and FIG. 2, an embodiment of this application provides a nitride epitaxial structure 100, including a substrate 10, a nucleation layer 20, a buffer layer 30, and an epitaxial layer 40. The nucleation layer 20 is an AlN layer or a GaN layer, and is formed on the substrate 10. The buffer layer 30 is formed on the nucleation layer 20. The epitaxial layer 40 is formed on the buffer layer 30. A material of the epitaxial layer 40 includes a group-III nitride. The buffer layer 30 includes K stacked group-III nitride double-layer structures 200, where K ≥ 3. Each double-layer structure 300 includes a lower layer 302 and an upper layer 301. A band gap of a material of the upper layer 301 is greater than a band gap of a material of the lower layer 302, to generate a band gap difference. The band gap difference of each double-layer structure 300 is a difference between the band gap of the material of the upper layer 301 and the band gap of the material of the lower layer 302. Band gap differences of the K double-layer structures generally present a gradient trend along a thickness direction of the buffer layer 30. The nitride epitaxial structure provided in this embodiment of this application has an epitaxial layer with good uniformity and high crystal quality, and may be used in a semiconductor device to improve device performance. The nitride epitaxial structure may have a nitride epitaxial layer with a large size of at least 6 inches and a thickness of at least 5 micrometers, to meet a requirement of a large-size epitaxial structure.

It should be noted that, for the upper layer and the lower layer of the double-structure in this application, the "upper" and the "lower" do not represent specific orientations. In the art, for a superlattice double-layer structure, usually, a layer with a larger band gap is written as an upper layer, and a layer with a smaller band gap is written as a lower layer. Even if the two layers are exchanged in order during actual growth, the writing is not changed.

In an implementation of this application. the substrate 10 may be a silicon substrate, a sapphire substrate, a silicon-on-insulator substrate (SOI substrate), a gallium nitride substrate, a gallium arsenide substrate, an indium phosphide substrate, an aluminum nitride substrate, a silicon carbide substrate, a quartz substrate, or a diamond substrate, or may be any known conventional substrate that can be used to prepare a group-III nitride film. A crystal orientation of the silicon substrate is not limited, for example, may be a silicon substrate with a crystal facet index of (111), or may be a silicon substrate with a crystal facet index of (100), or may be a silicon substrate with another crystal facet index.

In an implementation of this application, the nucleation layer 20 is a layer of aluminum nitride or gallium nitride film, and the nucleation layer 20 fully covers the substrate 10. The nucleation layer 20 may provide a nucleation center for subsequent growth of the nitride epitaxial layer, may alleviate stress generated between the substrate 10 and the epitaxial layer 40 due to a lattice mismatch, and may further effectively prevent impurities brought by the substrate 10 from affecting subsequent growth of the nitride epitaxial layer, to reduce lattice defects, reduce dislocation density, and improve crystal quality of the nitride epitaxial layer. In addition, the nucleation layer 20 is thin, and is monocrystalline or quasi-monocrystalline. Therefore, stress generated between the substrate 10 and the epitaxial layer 40 due to a lattice mismatch can be alleviated, without affecting subsequent crystal quality of the nitride epitaxial layer, and costs can also be effectively controlled. In some implementations of this application, a thickness of the nucleation layer 20 may be 10 nm to 300 nm. In some other implementations of this application, a thickness of the nucleation layer 20 may be 20 nm to 200 nm. In some other implementations of this application, a thickness of the nucleation layer 20 may be alternatively 50 nm to 150 nm.

In an implementation of this application, the nucleation layer 20 may be prepared in a manner of metal-organic chemical vapor deposition or molecular beam epitaxy. The metal-organic chemical vapor deposition (MOCVD, Metal-organic Chemical Vapor Deposition) is a chemical vapor deposition technology for growing a film through vapor phase epitaxy by using a thermal decomposition reaction of an organic metal compound. Specifically, an organic compound of group-III or group-II elements, a hydride of group-V or group-VI elements, and the like may be used as source materials for crystal growth of a metal organic compound, to grow a group-III-V or group II-VI compound film on a substrate by using a thermal decomposition reaction. The manner of metal-organic chemical vapor deposition can improve subsequent crystal quality of the nitride epitaxial layer.

In an implementation of this application, the buffer layer 30 includes K stacked group-III nitride double-layer structures 300. In some implementations, a value of K may be 3 to 100. In some other implementations, a value of K may be 10 to 60. In some other implementations, a value of K may be alternatively 20 to 50. In each double-layer structure, the material of the upper layer 301 and the material of the lower layer 302 each may be selected from one of GaN, AlN, InN, or a combination thereof: AlGaN, InGaN, InAlN, or InAlGaN. AlGaN is a combination of two types of group-III nitrides: GaN and AlN. InGaN is a combination of two types of group-III nitrides: GaN and InN. InAlN is a combination of two types of group-III nitrides: AlN and InN. InAlGaN is a combination of three types of group-III nitrides: GaN, AlN, and InN. A band gap of GaN is 3.4 eV, a band gap of AlN is 6.2 eV, and a band gap of InN is 0.7 eV. Specifically, a combination of the materials of the upper layer and the lower layer of the double-layer structure 300 may be AlN/GaN, AlGaN/GaN, AlN/AlGaN, or AlGaN/AlGaN.

In an implementation of this application, a thickness of the buffer layer 30 may be set based on a withstand voltage level. For example, if the withstand voltage level is 100 V, the buffer layer usually needs to be disposed to be 2 µm to 3 µm; or if the withstand voltage level is 600 V, the buffer layer needs to be disposed to be greater than 5 µm. In some implementations of this application, a thickness of the buffer layer 30 is greater than 300 nm. A thickness of each double-layer structure is less than 100 nm. Specifically, the thickness of each double-layer structure may be 10 nm to 80 nm, or 20 nm to 60 nm. An appropriate thickness of the double-layer structure helps avoid relaxation. In each double-layer structure 300, a thickness of the lower layer 302 is greater than twice a thickness of the upper layer 301. A thick lower layer and a thick upper layer are disposed, so that lattice relaxation can be effectively avoided. For heteroepitaxy, when the thickness of the upper layer is smaller, the material is in a strained state, to be specific, a lattice constant of the material of the upper layer is the same as that of the material of the lower layer after the material of the upper layer is stretched or compressed by the material of the lower layer, so that a superlattice can effectively function; or when the thickness of the upper layer is greater, the material is restored to a lattice constant of the material, causing lattice relaxation. In the K double-layer structures 300, thicknesses of all upper layers may be the same, and thicknesses of all lower layers may be the same.

In some implementations of this application, band gap differences of the K double-layer structures 300 gradually decrease from one side of the nucleation layer 200 to one side of the epitaxial layer 400. When the band gap difference is large, a difference between lattice constants of the materials of the double-layer structure is large, thereby helping filter dislocations. However, because a polarization effect is also strong, electric leakage is likely to occur. On the contrary, when the band gap difference is small, this helps reduce a leakage current, but is not conducive to dislocation filtering. A double-layer structure with a large band gap difference is disposed on a side close to the nucleation layer, thereby helping filter dislocations. In addition, because the double-layer structure is far away from an AlGaN barrier layer and a channel layer, adverse impact caused by electric leakage is small. A double-layer structure with a small band gap difference is disposed on a side close to the epitaxial layer, thereby helping reduce a polarization effect and improve voltage withstand performance. In some other implementations, alternatively, the K double-layer structures 300 may be arranged, according to a requirement, in a manner that band gap differences gradually increase from one side of the nucleation layer 200 to one side of the epitaxial layer 400.

In an implementation of this application, a difference between a largest band gap difference and a smallest band gap difference in the K double-layer structures is greater than 20% of a band gap difference between a group-III nitride with a largest band gap and a group-III nitride with a smallest band gap that constitute the double-layer structure. For example, in K AlGaN/AlGaN double-layer structures, group-III nitrides that constitute the double-layer structure include GaN and AlN, where a band gap of GaN is 3.4 eV, and a band gap of AlN is 6.2 eV. In this case, 20% of a band gap difference between a group-III nitride with a largest band gap and a group-III nitride with a smallest band gap that constitute the double-layer structure is 20% × (6.2 - 3.4) eV For another example, in K InAlGaN/InAlGaN double-layer structures, group-III nitrides that constitute the double-layer structure include InN, GaN, and AlN, where a band gap of InN is 0.7 eV, a band gap of GaN is 3.4 eV, and a band gap of AlN is 6.2 eV. In this case, 20% of a band gap difference between a group-III nitride with a largest band gap and a group-III nitride with a smallest band gap that constitute the double-layer structure is 20% × (6.2 - 0.7) eV.

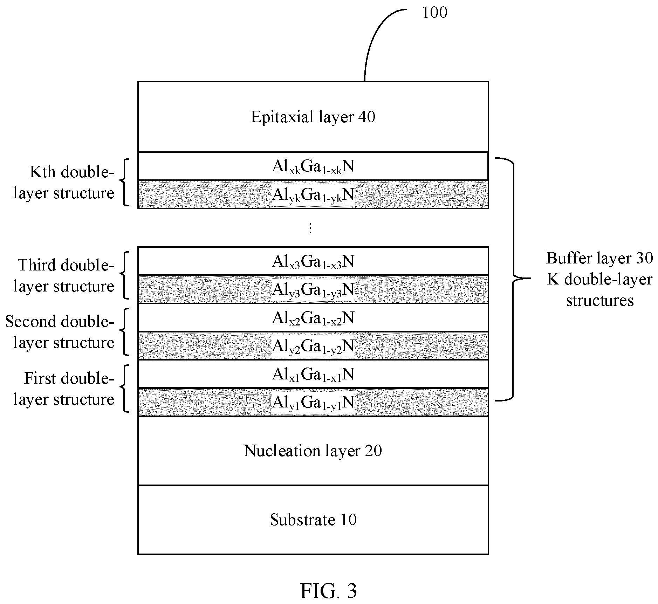

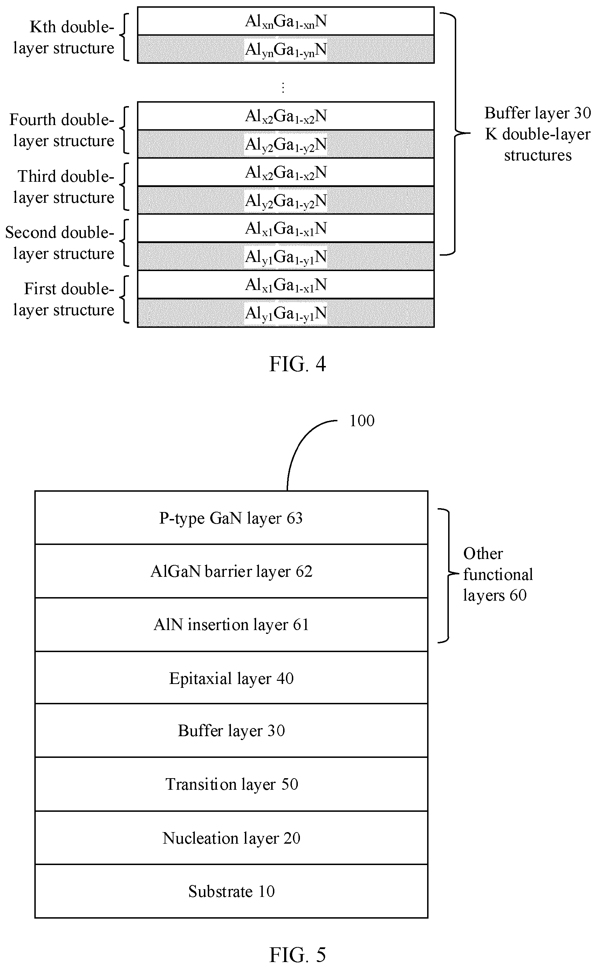

In some implementations of this application, the K double-layer structures 200 include two types of group-III nitrides: GaN and AlN, and a combination of the upper layer and the lower layer of the double-layer structure may be expressed as AlₓGa₁₋ₓN/Al_{y}Ga_{1-y}N (0 < x ≤ 1, y > 0). In the double-layer structures, a gradient trend of band gap differences may be equivalent to a gradient trend of Al component content differences. A change trend of band gaps and a change trend of an Al component content in AlGaN are approximately in a linear relationship. To be specific, a higher Al component content in AlGaN indicates a larger band gap. Therefore, a gradient trend of band gap differences of the double-layer structures may be equivalent to a gradient trend of Al component content differences of the double-layer structures. It should be noted that the Al component content in this application is a molar percentage of an Al element in group-III metal elements. A band gap of AlₓGa₁₋ₓN may be approximately equal to [6.2x + (1 - x) 3.4] eV Therefore, Al component contents in an upper layer and a lower layer of each double-layer structure are controlled, so that the Al component content differences of the double-layer structures are in a gradient trend, and therefore the band gap differences of the K double-layer structures can be gradient. For example, as shown in FIG. 2 and FIG. 3, the K double-layer structures 200 include a first double-layer structure Alₓ₁Ga₁₋ₓ₁N/Al_{y1}Ga_{1-y1}N, a second double-layer structure Alₓ₂Ga₁₋ₓ₂N/Al_{y2}Ga_{1-y2}N, a third double-layer structure Alₓ₃Ga₁₋ₓ₃N/Al_{y3}Ga_{1-y3}N, ..., and a Kth double-layer structure AlₓₖGa₁₋ₓₖN/Al_{yk}Ga_{1-yk}N. If band gap differences gradually decrease from the first double-layer structure to the Kth double-layer structure, x1 - y1 > x2 - y2 > x3 - y3 > ... > xk - yk, that is, Al component content differences gradually decrease from the first double-layer structure to the Kth double-layer structure. In this implementation, any two adjacent double-layer structures have different band gap differences. Specifically, any two adjacent double-layer structures have different components. In some other implementations of this application, in the K double-layer structures, some adjacent double-layer structures may have a same band gap difference. A repetition periodicity of double-layer structures that are adjacently stacked and that have a same band gap difference may be 1 to 10. Repetition periodicities of double-layer structures with different band gap differences may be the same or different. For example, as shown in FIG. 4, in a buffer layer constituted by AlₓGa₁₋ₓN/Al_{y}Ga_{1-y}N, repetition periodicities of double-layer structures with different band gap differences are the same, that is, are all 2. This may be as follows: a band gap difference of the first double-layer structure = a band gap difference of the second double-layer structure > a band gap difference of the third double-layer structure = a band gap difference of the fourth double-layer structure ... > a band gap difference of the Kth double-layer structure. Repetition periodicities of double-layer structures with different band gap differences are different, for example, a band gap difference of the first double-layer structure = a band gap difference of the second double-layer structure = a band gap difference of the third double-layer structure > a band gap difference of the fourth double-layer structure = a band gap difference of the fifth double-layer structure > a band gap difference of the sixth double-layer structure ... > a band gap difference of the Kth double-layer structure.

According to the invention, the K double-layer structures include two types of group-III nitrides: GaN and AlN, and an average Al component content in each double-layer structure is 15% to 30%. In some other implementations, an average Al component content in each group-III nitride double-layer structure is 20% to 25%. The average Al component content is an average molar percentage of an Al element in group-III metal elements in each double-layer structure. The average Al component content of each double-layer structure is controlled within an appropriate range, to ensure that the buffer layer has good crystal quality. For the AlₓGa₁₋ₓN/Al_{y}Ga_{1-y}N double-layer structure, an average Al component content in each double-layer structure may be expressed as [(Tᵤₚₚₑᵣ × x + T_{lower} × y)/(Tᵤₚₚₑᵣ + T_{lower})] × 100%, where Tᵤₚₚₑᵣ and T_{lower} indicate thicknesses of an upper layer and a lower layer of the double-layer structure respectively, and x and y indicate Al component contents of the upper layer and the lower layer respectively. The average Al component content in each double-layer structure is the same. An Al component remains unchanged. Therefore, when pre-compensation is designed for high-temperature warpage, only impact of a thickness of a film layer needs to be considered, and impact of a change of the Al component does not need to be considered, thereby simplifying a parameter design.

In addition, in this application, that the band gap differences of the K double-layer structures generally present a gradual tend along the thickness direction of the buffer layer may be that the band gap differences strictly present a change of gradually increasing or gradually decreasing along the thickness direction of the buffer layer, or may be that the band gap differences generally present a change of gradually increasing or gradually decreasing, but there are a few special cases in which a change is opposite to the overall gradient trend, for example, in a buffer layer in which band gap differences generally gradually increase, there are a few double-layer structures whose band gap differences gradually decrease.

In an implementation of this application, a material of the epitaxial layer includes one or more of GaN, AlN, InN, AlGaN, InGaN, InAlN, and InAlGaN. In an implementation of this application, a material of the epitaxial layer 40 includes a group-III nitride, and may be specifically, for example, one or more of GaN, AlN, InN, AlGaN, InGaN, InAlN, and InAlGaN. A thickness of the epitaxial layer 40 is greater than or equal to 300 nm. A thickness of a conventional gallium nitride epitaxial layer is usually small due to a limitation of stress. However, the nitride epitaxial structure in this embodiment of this application can well eliminate stress, and therefore is applicable to preparation of a thick-film epitaxial layer, and theoretically may have an infinite thickness. In some implementations of this application, a thickness of the epitaxial layer may be greater than or equal to 5 µm, or may be greater than or equal to 10 µm, for example, 15 µm to 100 µm. The epitaxial layer 40 may fully cover the nucleation layer 20, or may partially cover the nucleation layer 20.

In an implementation of this application, different nitride epitaxial layers are applicable to different semiconductor devices. For example, GaN, AlGaN, and AlN are applicable to power devices, and a nitride epitaxial layer including In is applicable to photoelectric devices.

In this implementation of this application, to meet a usability requirement, another element may be alternatively added to the epitaxial layer 40. For example, to improve insulation, carbon may be added to achieve a high resistance and improve voltage withstand performance.

As shown in FIG. 5, the nitride epitaxial structure 100 further includes a transition layer 50 disposed between the nucleation layer 30 and the epitaxial layer 40, and the transition layer 50 may be an AlGaN layer. A thickness of the transition layer may be 10 nm to 300 nm. The transition layer 50 is disposed, thereby helping adjust stress applied to the epitaxial structure.

In an implementation of this application, as shown in FIG. 5, the nitride epitaxial structure 100 further includes other functional layers 60 disposed on the epitaxial layer 40. A specific structural composition of the other functional layers 60 may be arranged according to an actual application requirement. In an implementation of this application, the other functional layers 60 may specifically include an AlN insertion layer 61, an AlGaN barrier layer 62, and a P-type GaN layer 63 that are sequentially disposed on the epitaxial layer 40. In some other implementations, the other functional layers 60 may alternatively have another structure.

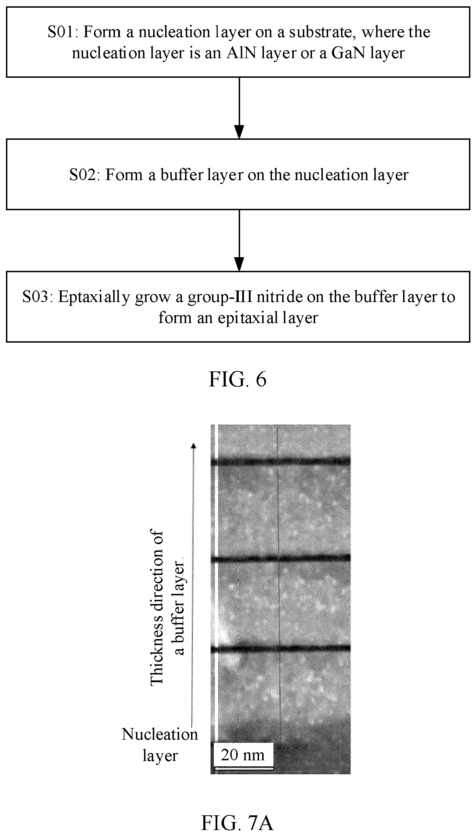

As shown in FIG. 6, an embodiment of this application further provides a method for preparing a nitride epitaxial structure, including the following steps.

S01: Form a nucleation layer on a substrate, where the nucleation layer is an AlN layer or a GaN layer.

Specifically, the nucleation layer 20 may be prepared on the substrate 10 in a manner of metal-organic chemical vapor deposition or molecular beam epitaxy. Before preparation of the nucleation layer 20, conventional cleaning may be performed on the substrate 10.

In a specific implementation of this application, the nucleation layer 20 is prepared on the substrate 10 in a manner of metal-organic chemical vapor deposition. Details may be as follows: The substrate 10 is placed in a metal-organic chemical vapor deposition reaction chamber, and hydrogen and ammonia are injected for 3 min to 5 min at a temperature of 900°C to 1100°C and under a pressure of 30 to 60 Torr, to obtain a processed substrate 10. Then hydrogen, ammonia, and an aluminum source or a gallium source are injected, and an aluminum nitride or a gallium nitride is deposited on the processed substrate 10, to obtain the nucleation layer 20. In this implementation of this application, the parameters in the deposition process are not limited to the foregoing ranges. The gallium source includes but is not limited to trimethyl gallium and triethyl gallium. The aluminum source includes but is not limited to trimethyl aluminum and triethyl aluminum.

S02: Form a buffer layer on the nucleation layer.

In an implementation of this application, the buffer layer 30 may be prepared in a manner of metal-organic chemical vapor deposition. Specifically, the substrate with the nucleation layer that is obtained in step S01 is placed in a metal-organic chemical vapor deposition reaction chamber. Then hydrogen, ammonia, and a group-III metal source are injected at a temperature of 900°C to 1100°C and under a pressure of 30 to 60 Torr, and a group-III nitride is obtained through epitaxial growth on the buffer layer 30, to obtain the buffer layer 30. The group-III metal source is an organic compound including a group-III metal element, for example, trimethyl gallium, triethyl gallium, trimethyl aluminum, or triethyl aluminum. A flux of the group-III metal source may be changed to change a content of each group-III nitride in the buffer layer, and deposition time may be controlled to obtain nitride layers of different thicknesses.

S03: Epitaxially grow a group-III nitride on the buffer layer to form an epitaxial layer.

In an implementation of this application, the epitaxial layer 40 may be prepared in a manner of metal-organic chemical vapor deposition. Specifically, the substrate 10 obtained in step S02 is placed in a metal-organic chemical vapor deposition reaction chamber, and hydrogen and ammonia are injected for 3 min to 5 min at a temperature of 900°C to 1100°C and under a pressure of 30 to 60 Torr, to obtain a processed substrate 10. Then hydrogen, ammonia, and a group-III metal source are injected, and a group-III nitride is obtained through epitaxial growth on the buffer layer 30, to form the epitaxial layer 40. The group-III nitride may be specifically, for example, one or more of GaN, AlN, InN, AlGaN, InGaN, InAlN, and InAlGaN. The group-III metal source is an organic compound including a group-III metal element. for example, trimethyl gallium, triethyl gallium, trimethyl aluminum, or triethyl aluminum.

In an implementation of this application, the preparation method may further include: forming a transition layer 50 between the buffer layer 30 and the epitaxial layer 40. To be specific, before step S03, the transition layer 50 is first prepared on the buffer layer 30, and then the epitaxial layer 40 is grown on the transition layer 50. A material of the transition layer 50 may be an AlGaN layer.

An embodiment of this application further provides a semiconductor device, including the foregoing nitride epitaxial structure provided in embodiments of this application. The nitride epitaxial structure in embodiments of this application may be directly used as a part of the semiconductor device, or it may be separately used in the semiconductor device. The semiconductor device includes but is not limited to a power device (namely, an electronic power device), a radio frequency device. or a photoelectric device. The power device or the radio frequency device may be a transistor, and may be specifically a field-effect transistor, for example, a high electron mobility transistor (High Electron Mobility Transistor, HEMT). The photoelectric device is, for example, a light emitting diode (Light Emitting Diode, LED) or a laser diode (Laser diode, LD), and may be specifically a nitride-based light emitting diode or a nitride-based quantum well laser diode.

The following further describes embodiments of this application by using a plurality of embodiments.

### Embodiment 1

A nitride epitaxial structure includes a substrate, and a nucleation layer, a buffer layer, an epitaxial layer, and other functional layers that are sequentially disposed on the substrate. A material of the substrate is Si, sapphire, GaN, SiC, diamond, SOI, or the like. The nucleation layer is an AlN nucleation layer with a thickness of 50 nm to 400 nm. The buffer layer is a structural layer with gradient band gap differences, and includes 11 double-layer structures with an upper layer and a lower layer of AlₓGa₁₋ₓN/Al_{y}Ga_{1-y}N. An average Al component content of each double-layer structure is 20%. Table 1 shows values of x and y and thicknesses Tᵤₚₚₑᵣ and T_{lower} in each double-layer structure. The epitaxial layer is a GaN layer, may include a carbon-doped structure such as GaN or AlGaN, and has a thickness of 100 nm to 3 µm. The other functional layers may include the following layers that are sequentially disposed on the epitaxial layer: an AlN insertion layer with a thickness of 1 nm; an AlGaN barrier layer with an Al component range of 10% to 30% and a thickness of 10 nm to 30 nm; and a p-GaN layer, where a P-type impurity is implemented through Mg doping, and a thickness range is 30 nm to 120 nm.

**Table 1 Buffer layer parameters in Embodiment 1**

| Double-layer structure sequence number | x | y | Al component content difference | Tᵤₚₚₑᵣ (nm) | T_{lower} (nm) | Average Al component content | Periodicity |
|---|---|---|---|---|---|---|---|
| 1 | 0.5 | 0.17 | 0.33 | 2 | 20 | 20% | 5 |
| 2 | 0.55 | 0.165 | 0.385 | 2 | 20 | 20% | 5 |
| 3 | 0.6 | 0.16 | 0.44 | 2 | 20 | 20% | 5 |
| 4 | 0.65 | 0.155 | 0.495 | 2 | 20 | 20% | 5 |
| 5 | 0.7 | 0.15 | 0.55 | 2 | 20 | 20% | 5 |
| 6 | 0.75 | 0.145 | 0.605 | 2 | 20 | 20% | 5 |
| 7 | 0.8 | 0.14 | 0.66 | 2 | 20 | 20% | 5 |
| 8 | 0.85 | 0.135 | 0.715 | 2 | 20 | 20% | 5 |
| 9 | 0.9 | 0.13 | 0.77 | 2 | 20 | 20% | 5 |
| 10 | 0.95 | 0.125 | 0.825 | 2 | 20 | 20% | 5 |
| 11 | 1.0 | 0.12 | 0.88 | 2 | 20 | 20% | 5 |

Double-layer structures whose sequence numbers are 1 to 11 are sequentially disposed in a stacked manner. A double-layer structure with a sequence number of 1 is disposed close to the epitaxial layer, and a double-layer structure with a sequence number of 11 is disposed close to the nucleation layer. The periodicity 5 in Table 1 means that a double-layer structure with each sequence number is repeated five times. To be specific, double-layer structures with different band gap differences have a same repetition periodicity, to form 11 groups of double-layer structures, and each group includes five same double-layer structures that are stacked. To be specific, the buffer layer includes five stacked Al_{0.5}Ga_{0.5}N/Al_{0.17}Ga_{0.83}N double-layer structures, five stacked Al_{0.55}Ga_{0.45}N/Al_{0.165}Ga_{0.835}N double-layer structures, and so on. It can be learned from Table 1 that, in the nitride epitaxial structure in Embodiment 1, Al component content differences of the 11 groups of double-layer structures of the buffer layer gradually decrease from one side of the nucleation layer to one side of the epitaxial layer, that is, band gap differences of the 11 groups of double-layer structures gradually decrease from one side of the nucleation layer to one side of the epitaxial layer. In addition, an average Al component content of each group of double-layer structures in Embodiment 1 is the same, and is 20%.

### Embodiment 2

A difference from Embodiment 1 lies only in that the buffer layer includes 51 double-layer structures with an upper-layer and a lower layer of AlₓGa₁₋ₓN/Al_{y}Ga_{1-y}N. Table 2 shows values of x and y, an upper-layer thickness Tᵤₚₚₑᵣ, and a lower-layer thickness T_{lower} in each double-layer structure.

**Table 2 Buffer layer parameters in Embodiment 2**

| Double-layer structure sequence number | x | y | Al component content difference | Tᵤₚₚₑᵣ (nm) | T_{lower} (nm) | Average Al component content | Periodicity |
|---|---|---|---|---|---|---|---|
| 1 | 0.5 | 0.170 | 0.330 | 2 | 20 | 20% | 1 |
| 2 | 0.51 | 0.169 | 0.341 | 2 | 20 | 20% | 1 |
| 3 | 0.52 | 0.168 | 0.352 | 2 | 20 | 20% | 1 |
| 4 | 0.53 | 0.167 | 0.363 | 2 | 20 | 20% | 1 |
| 5 | 0.54 | 0.166 | 0.374 | 2 | 20 | 20% | 1 |
| 6 | 0.55 | 0.165 | 0.385 | 2 | 20 | 20% | 1 |
| 7 | 0.56 | 0.164 | 0.396 | 2 | 20 | 20% | 1 |
| 8 | 0.57 | 0.163 | 0.407 | 2 | 20 | 20% | 1 |
| 9 | 0.58 | 0.162 | 0.418 | 2 | 20 | 20% | 1 |
| 10 | 0.59 | 0.161 | 0.429 | 2 | 20 | 20% | 1 |
| 11 | 0.6 | 0.160 | 0.440 | 2 | 20 | 20% | 1 |
| 12 | 0.61 | 0.159 | 0.451 | 2 | 20 | 20% | 1 |
| 13 | 0.62 | 0.158 | 0.462 | 2 | 20 | 20% | 1 |
| 14 | 0.63 | 0.157 | 0.473 | 2 | 20 | 20% | 1 |
| 15 | 0.64 | 0.156 | 0.484 | 2 | 20 | 20% | 1 |
| 16 | 0.65 | 0.155 | 0.495 | 2 | 20 | 20% | 1 |
| 17 | 0.66 | 0.154 | 0.506 | 2 | 20 | 20% | 1 |
| 18 | 0.67 | 0.153 | 0.517 | 2 | 20 | 20% | 1 |
| 19 | 0.68 | 0.152 | 0.528 | 2 | 20 | 20% | 1 |
| 20 | 0.69 | 0.151 | 0.539 | 2 | 20 | 20% | 1 |
| 21 | 0.7 | 0.150 | 0.550 | 2 | 20 | 20% | 1 |
| 22 | 0.71 | 0.149 | 0.561 | 2 | 20 | 20% | 1 |
| 23 | 0.72 | 0.148 | 0.572 | 2 | 20 | 20% | 1 |
| 24 | 0.73 | 0.147 | 0.583 | 2 | 20 | 20% | 1 |
| 25 | 0.74 | 0.146 | 0.594 | 2 | 20 | 20% | 1 |
| 26 | 0.75 | 0.145 | 0.605 | 2 | 20 | 20% | 1 |
| 27 | 0.76 | 0.144 | 0.616 | 2 | 20 | 20% | 1 |
| 28 | 0.77 | 0.143 | 0.627 | 2 | 20 | 20% | 1 |
| 29 | 0.78 | 0.142 | 0.638 | 2 | 20 | 20% | 1 |
| 30 | 0.79 | 0.141 | 0.649 | 2 | 20 | 20% | 1 |
| 31 | 0.80 | 0.140 | 0.660 | 2 | 20 | 20% | 1 |
| 32 | 0.81 | 0.139 | 0.671 | 2 | 20 | 20% | 1 |
| 33 | 0.82 | 0.138 | 0.682 | 2 | 20 | 20% | 1 |
| 34 | 0.83 | 0.137 | 0.693 | 2 | 20 | 20% | 1 |
| 35 | 0.84 | 0.136 | 0.704 | 2 | 20 | 20% | 1 |
| 36 | 0.85 | 0.135 | 0.715 | 2 | 20 | 20% | 1 |
| 37 | 0.86 | 0.134 | 0.726 | 2 | 20 | 20% | 1 |
| 38 | 0.87 | 0.133 | 0.737 | 2 | 20 | 20% | 1 |
| 39 | 0.88 | 0.132 | 0.748 | 2 | 20 | 20% | 1 |
| 40 | 0.89 | 0.131 | 0.759 | 2 | 20 | 20% | 1 |
| 41 | 0.90 | 0.130 | 0.770 | 2 | 20 | 20% | 1 |
| 42 | 0.91 | 0.129 | 0.781 | 2 | 20 | 20% | 1 |
| 43 | 0.92 | 0.128 | 0.792 | 2 | 20 | 20% | 1 |
| 44 | 0.93 | 0.127 | 0.803 | 2 | 20 | 20% | 1 |
| 45 | 0.94 | 0.126 | 0.814 | 2 | 20 | 20% | 1 |
| 46 | 0.95 | 0.125 | 0.825 | 2 | 20 | 20% | 1 |
| 47 | 0.96 | 0.124 | 0.836 | 2 | 20 | 20% | 1 |
| 48 | 0.97 | 0.123 | 0.847 | 2 | 20 | 20% | 1 |
| 49 | 0.98 | 0.122 | 0.858 | 2 | 20 | 20% | 1 |
| 50 | 0.99 | 0.121 | 0.869 | 2 | 20 | 20% | 1 |
| 51 | 1.00 | 0.120 | 0.880 | 2 | 20 | 20% | 1 |

Double-layer structures whose sequence numbers are 1 to 51 are sequentially disposed in a stacked manner. A double-layer structure with a sequence number of 1 is disposed close to the epitaxial layer, and a double-layer structure with a sequence number of 51 is disposed close to the nucleation layer. The periodicity 1 in Table 2 means that there is only one double-layer structure with each sequence number. It can be learned from Table 2 that, in the nitride epitaxial structure in Embodiment 2, Al component content differences of the 51 double-layer structures of the buffer layer gradually decrease from one side of the nucleation layer to one side of the epitaxial layer, that is, band gap differences of the 51 double-layer structures gradually decrease from one side of the nucleation layer to one side of the epitaxial layer. In addition, an average Al component content of each double-layer structure in Embodiment 2 is the same, and is 20%. Compared with Embodiment 1, a gradient spacing between band gap differences of the buffer layer in Embodiment 2 is smaller, so that stress between the substrate and the epitaxial layer can be better adjusted.

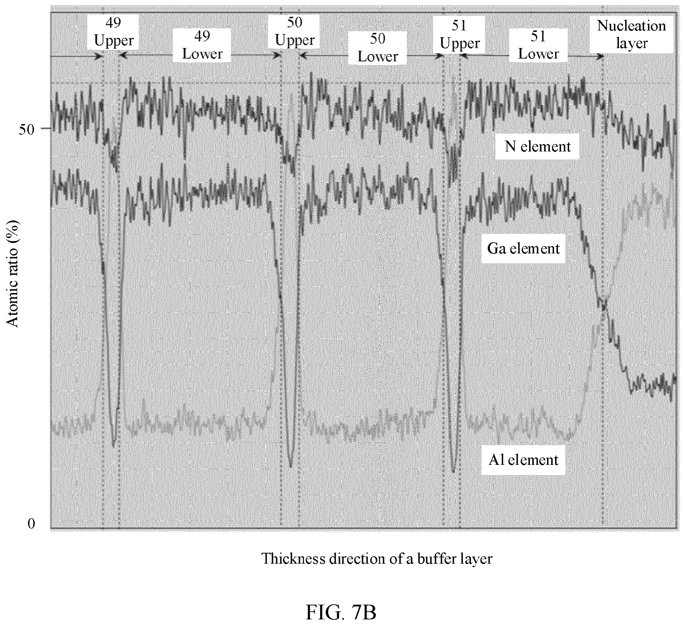

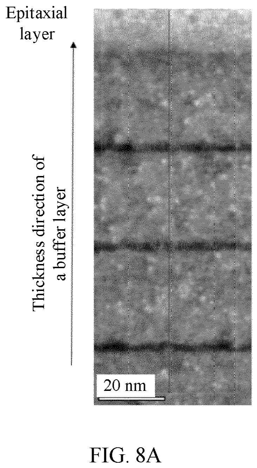

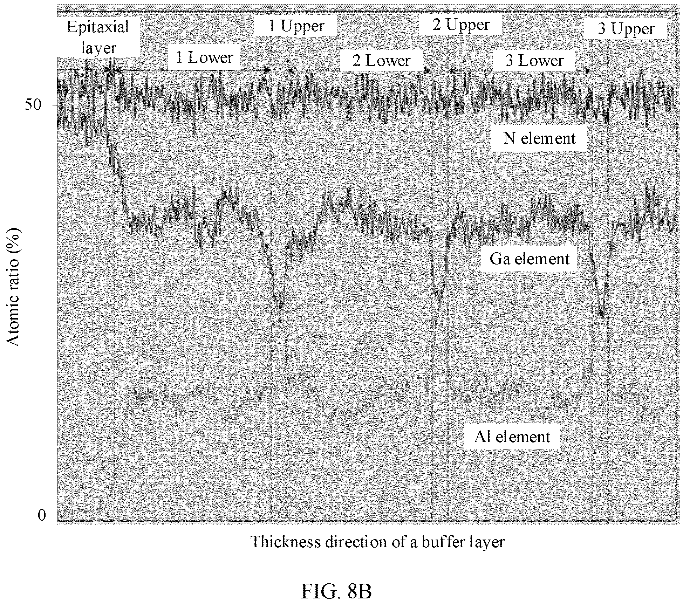

FIG. 7A is a TEM graph of a double-layer structure, of the buffer layer, that is close to a side of the substrate in the nitride epitaxial structure according to Embodiment 2. FIG. 7B is an EDS graph of a double-layer structure, of the buffer layer, that is close to a side of the substrate in the nitride epitaxial structure according to Embodiment 2. The double-layer structure in FIG. 7B corresponds to three double-layer structures whose sequence numbers are 49 to 51 in Table 2. It can be learned from FIG. 7A and FIG. 7B that, in a double-layer structure close to a side of the substrate, an Al component in an upper layer with a large band gap is close to 100%, and Al components present a gradual decrease trend toward a side away from the substrate. FIG. 8A is a TEM graph of a double-layer structure, of the buffer layer, that is close to a side of the epitaxial layer in the nitride epitaxial structure according to Embodiment 2. FIG. 8B is an EDS graph of a double-layer structure, of the buffer layer, that is close to a side of the epitaxial layer in the nitride epitaxial structure according to Embodiment 2. The double-layer structure in FIG. 8B corresponds to three double-layer structures whose sequence numbers are 1 to 3 in Table 2. It can be learned from FIG. 7B and FIG. 8B that, an Al content difference of a double-layer structure close to a side of the substrate is greater than an Al content difference of a double-layer structure close to a side of the epitaxial layer.

Note: The EDS graph includes curves for three elements: Ga, Al, and N. The N element accounts for approximately 50%. Therefore, a vertical-coordinate value of each point on a curve for the Al element multiplied by 2 is an Al component content. Due to factors such as measurement errors, a measured value may be different from a designed value.

## Claims

1. A nitride epitaxial structure (100), comprising:
a substrate (10);
a nucleation layer (20), formed on the substrate (10), wherein the nucleation layer (20) is an aluminum nitride layer or a gallium nitride layer;
a buffer layer (30), formed on the nucleation layer (20), wherein the buffer layer (30) comprises K stacked group-III nitride double-layer structures, K ≥ 3, each double-layer structure comprises an upper layer (301) and a lower layer (302) that are stacked, a band gap of a material of the upper layer (301) is greater than a band gap of a material of the lower layer (302), a band gap difference of each double-layer structure is a difference between the band gap of the material of the upper layer (301) and the band gap of the material of the lower layer (302), and band gap differences of the K double-layer structures present a gradient trend along a thickness direction of the buffer layer (30); and
an epitaxial layer (40), formed on the buffer layer (30), wherein a material of the epitaxial layer (40) comprises group-III nitride,
wherein the K double-layer structures comprise GaN and AlN, and an average Al component content in each double-layer structure is 15% to 30%, wherein the average Al component content is an average molar percentage of an Al element in group-III metal elements in each double-layer structure, and the average Al component content in each double-layer structure is the same.

2. The nitride epitaxial structure (100) according to claim 1, wherein the material of the upper layer (301) and the material of the lower layer (302) each are selected from one of GaN, AlN, InN, or a combination thereof.

3. The nitride epitaxial structure (100) according to claim 1 or 2, wherein a thickness of the lower layer (302) is greater than twice a thickness of the upper layer (301).

4. The nitride epitaxial structure (100) according to any one of claims 1 to 3, wherein the band gap differences of the K double-layer structures gradually decrease from one side of the nucleation layer (20) to one side of the epitaxial layer (40).

5. The nitride epitaxial structure (100) according to any one of claims 1 to 4, wherein a difference between a largest band gap difference and a smallest band gap difference in the K double-layer structures is greater than 20% of a band gap difference between a group-III nitride with a largest band gap and a group-III nitride with a smallest band gap that constitute the double-layer structure.

6. The nitride epitaxial structure (100) according to any one of claims 1 to 5, wherein a thickness of each double-layer structure is less than 100 nm.

7. The nitride epitaxial structure (100) according to any one of claims 1 to 6, wherein a material of the epitaxial layer (40) comprises one or more of GaN, AlN, InN, AlGaN, InGaN, InAlN and InAlGaN.

8. The nitride epitaxial structure (100) according to any one of claims 1 to 7, wherein a thickness of the epitaxial layer (40) is greater than or equal to 300 nm.

9. The nitride epitaxial structure (100) according to any one of claims 1 to 8, wherein the substrate (10) comprises a silicon substrate, a sapphire substrate, a silicon-on-insulator substrate, a gallium nitride substrate, a gallium arsenide substrate, an indium phosphide substrate, an aluminum nitride substrate, a silicon carbide substrate, a quartz substrate, or a diamond substrate.

10. The nitride epitaxial structure (100) according to any one of claims 1 to 9, wherein a thickness of the nucleation layer (20) is 10 nm to 300 nm.

11. A semiconductor device, comprising the nitride epitaxial structure (100) according to any one of claims 1 to 10.

12. The semiconductor device according to claim 11, wherein the semiconductor device comprises a power device, a radio frequency device, or a photoelectric device.

13. The semiconductor device according to claim 11 or 12, wherein the semiconductor device comprises a field-effect transistor, a light emitting diode, or a laser diode.

## Patentansprüche

1. Nitrid-Epitaxiestruktur (100), die umfasst:
ein Substrat (10);
eine Nukleationsschicht (20), die auf dem Substrat (10) ausgebildet ist, wobei die Nukleationsschicht (20) eine Aluminiumnitridschicht oder eine Galliumnitridschicht ist;
eine Pufferschicht (30), die auf der Nukleationsschicht (20) ausgebildet ist, wobei die Pufferschicht (30) K gestapelte Gruppe-III-Nitrid-Doppelschichtstrukturen umfasst, K ≥ 3, jede Doppelschichtstruktur eine obere Schicht (301) und eine untere Schicht (302), die gestapelt sind, umfasst, eine Bandlücke eines Materials der oberen Schicht (301) größer als eine Bandlücke eines Materials der unteren Schicht (302) ist, eine Bandlückendifferenz jeder Doppelschichtstruktur eine Differenz zwischen der Bandlücke des Materials der oberen Schicht (301) und der Bandlücke des Materials der unteren Schicht (302) ist, und Bandlückendifferenzen der K Doppelschichtstrukturen einen Gradiententrend entlang einer Dickenrichtung der Pufferschicht (30) vorweisen; und
eine Epitaxieschicht (40), die auf der Pufferschicht (30) ausgebildet ist, wobei ein Material der Epitaxieschicht (40) Gruppe-III-Nitrid umfasst,
wobei die K Doppelschichtstrukturen GaN und AIN umfassen und ein durchschnittlicher Al-Komponentengehalt in jeder Doppelschichtstruktur 15 % bis 30 % beträgt, wobei der durchschnittliche Al-Komponentengehalt ein durchschnittlicher Molprozentsatz eines Al-Elements in Gruppe-III-Metallelementen in jeder Doppelschichtstruktur ist und der durchschnittliche Al-Komponentengehalt in jeder Doppelschichtstruktur der gleiche ist.

2. Nitrid-Epitaxiestruktur (100) nach Anspruch 1, wobei das Material der oberen Schicht (301) und das Material der unteren Schicht (302) jeweils aus einem von GaN, AIN, InN oder einer Kombination davon ausgewählt sind.

3. Nitrid-Epitaxiestruktur (100) nach Anspruch 1 oder 2, wobei eine Dicke der unteren Schicht (302) größer als eine doppelte Dicke der oberen Schicht (301) ist.

4. Nitrid-Epitaxiestruktur (100) nach einem der Ansprüche 1 bis 3, wobei die Bandlückendifferenzen der K Doppelschichtstrukturen von einer Seite der Nukleationsschicht (20) zu einer Seite der Epitaxieschicht (40) allmählich abnehmen.

5. Nitrid-Epitaxiestruktur (100) nach einem der Ansprüche 1 bis 4, wobei eine Differenz zwischen einer größten Bandlückendifferenz und einer kleinsten Bandlückendifferenz in den K Doppelschichtstrukturen größer als 20 % einer Bandlückendifferenz zwischen einem Gruppe-III-Nitrid mit einer größten Bandlückendifferenz und einem Gruppe-III-Nitrid mit einer kleinsten Bandlückendifferenz, die die Doppelschichtstruktur ausbilden, ist.

6. Nitrid-Epitaxiestruktur (100) nach einem der Ansprüche 1 bis 5, wobei eine Dicke jeder Doppelschichtstruktur weniger als 100 nm beträgt.

7. Nitrid-Epitaxiestruktur (100) nach einem der Ansprüche 1 bis 6, wobei ein Material der Epitaxieschicht (40) eines oder mehrere von GaN, AIN, InN, AlGaN, InGaN, InAlN und InAlGaN umfasst.

8. Nitrid-Epitaxiestruktur (100) nach einem der Ansprüche 1 bis 7, wobei eine Dicke der Epitaxieschicht (40) größer als oder gleich 300 nm ist.

9. Nitrid-Epitaxiestruktur (100) nach einem der Ansprüche 1 bis 8, wobei das Substrat (10) ein Siliziumsubstrat, ein Saphirsubstrat, ein Silizium-auf-Isolator-Substrat, ein Galliumnitridsubstrat, ein Galliumarsenidsubstrat, ein Indiumphosphidsubstrat, ein Aluminiumnitridsubstrat, ein Siliziumkarbidsubstrat, ein Quarzsubstrat oder ein Diamantsubstrat umfasst.

10. Nitrid-Epitaxiestruktur (100) nach einem der Ansprüche 1 bis 9, wobei eine Dicke der Nukleationsschicht (20) 10 nm bis 300 nm beträgt.

11. Halbleitervorrichtung, die die Nitrid-Epitaxiestruktur (100) nach einem der Ansprüche 1 bis 10 umfasst.

12. Halbleitervorrichtung nach Anspruch 11, wobei die Halbleitervorrichtung eine Leistungsvorrichtung, eine Hochfrequenzvorrichtung oder eine fotoelektrische Vorrichtung umfasst.

13. Halbleitervorrichtung nach Anspruch 11 oder 12, wobei die Halbleitervorrichtung einen Feldeffekttransistor, eine Leuchtdiode oder eine Laserdiode umfasst.

## Revendications

1. **Structure** épitaxiale de nitrure (100), comprenant :
un substrat (10) ;
une couche de nucléation (20), formée sur le substrat (10), dans laquelle la couche de nucléation (20) est une couche de nitrure d'aluminium ou une couche de nitrure de gallium ;
une couche tampon (30), formée sur la couche de nucléation (20), dans laquelle la couche tampon (30) comprend des structures à double couche de nitrure du groupe III empilées K, K ≥ 3, chaque structure à double couche comprend une couche supérieure (301) et une couche inférieure (302) qui sont empilées, une bande interdite d'un matériau de la couche supérieure (301) est supérieure à une bande interdite d'un matériau de la couche inférieure (302), une différence de bande interdite de chaque structure à double couche est une différence entre la bande interdite du matériau de la couche supérieure (301) et la bande interdite du matériau de la couche inférieure (302), et les différences de bande interdite des K structures à double couche présentent une tendance de gradient le long d'une direction d'épaisseur de la couche tampon (30) ; et
une couche épitaxiale (40), formée sur la couche tampon (30), dans laquelle un matériau de la couche épitaxiale (40) comprend du nitrure du groupe III,
dans laquelle les structures à double couche K comprennent du GaN et de l'AIN, et la teneur moyenne en composant Al de chaque structure à double couche va de 15 % à 30 %, dans laquelle la teneur moyenne en composant Al est un pourcentage molaire moyen d'un élément Al dans les éléments métalliques du groupe III dans chaque structure à double couche, et la teneur moyenne en composant Al de chaque structure à double couche est la même.

2. Structure épitaxiale de nitrure (100) selon la revendication 1, dans laquelle le matériau de la couche supérieure (301) et le matériau de la couche inférieure (302) sont chacun choisis parmi GaN, AIN, InN, ou une combinaison de ceux-ci.

3. Structure épitaxiale de nitrure (100) selon la revendication 1 ou 2, dans laquelle une épaisseur de la couche inférieure (302) est supérieure à deux fois une épaisseur de la couche supérieure (301).

4. Structure épitaxiale de nitrure (100) selon l'une quelconque des revendications 1 à 3, dans laquelle les différences de bande interdite des structures à double couche K diminuent progressivement d'un côté de la couche de nucléation (20) à un côté de la couche épitaxiale (40).

5. Structure épitaxiale de nitrure (100) selon l'une quelconque des revendications 1 à 4, dans laquelle une différence entre la plus grande différence de bande interdite et la plus petite différence de bande interdite dans les structures à double couche K est supérieure à 20 % d'une différence de bande interdite entre un nitrure de groupe III ayant la plus grande bande interdite et un nitrure de groupe III ayant la plus petite bande interdite qui constituent la structure à double couche.

6. Structure épitaxiale de nitrure (100) selon l'une quelconque des revendications 1 à 5, dans laquelle une épaisseur de chaque structure à double couche est inférieure à 100 nm.

7. Structure épitaxiale de nitrure (100) selon l'une quelconque des revendications 1 à 6, dans laquelle un matériau de la couche épitaxiale (40) comprend un ou plusieurs GaN, AIN, InN, AlGaN, InGaN, InAlN et InAlGaN.

8. Structure épitaxiale de nitrure (100) selon l'une quelconque des revendications 1 à 7, dans laquelle une épaisseur de la couche épitaxiale (40) est supérieure ou égale à 300 nm.

9. Structure épitaxiale de nitrure (100) selon l'une quelconque des revendications 1 à 8, dans laquelle le substrat (10) comprend un substrat de silicium, un substrat de saphir, un substrat de silicium sur isolant, un substrat de nitrure de gallium, un substrat d'arséniure de gallium, un substrat de phosphure d'indium, un substrat de nitrure d'aluminium, un substrat de carbure de silicium, un substrat de quartz ou un substrat de diamant.

10. Structure épitaxiale de nitrure (100) selon l'une quelconque des revendications 1 à 9, dans laquelle une épaisseur de la couche de nucléation (20) va de 10 nm à 300 nm.

11. Dispositif de semi-conducteur, comprenant la structure épitaxiale de nitrure (100) selon l'une quelconque des revendications 1 à 10.

12. Dispositif semi-conducteur selon la revendication 11, dans lequel le dispositif semi-conducteur comprend un dispositif de puissance, un dispositif de radiofréquence ou un dispositif photoélectrique.

13. Dispositif semi-conducteur selon la revendication 11 ou 12, dans lequel le dispositif semi-conducteur comprend un transistor à effet de champ, une diode électroluminescente ou une diode laser.
